Europäisches Patentamt

(19) European Patent Office  (11) Publication number: **0 116 927**
Office européen des brevets  **B1**

(12) **EUROPEAN PATENT SPECIFICATION**

(45) Date of publication of patent specification: **24.10.90**  (51) Int. Cl.⁵: **H 01 L 23/52**

(21) Application number: **84101444.2**

(22) Date of filing: **14.02.84**

(54) An interconnection change pad for use on a ceramic substrate receiving integrated circuit chips.

(30) Priority: **22.02.83 US 468262**

(43) Date of publication of application:
**29.08.84 Bulletin 84/35**

(45) Publication of the grant of the patent:
**24.10.90 Bulletin 90/43**

(84) Designated Contracting States:
**DE FR GB**

(56) References cited:
**EP-A-0 083 406**
**US-A-3 691 290**
**US-A-4 245 273**

**IBM TECHNICAL DISCLOSURE BULLETIN, vol.
24, no. 11A, April 1982, pages 5554-5557, New
York, US; E. HUBACHER: "Shared EC pad
design"**

(73) Proprietor: **International Business Machines
Corporation
Old Orchard Road
Armonk, N.Y. 10504 (US)**

(72) Inventor: **Feinberg, Irving
13 Meadow View Drive
Poughkeepsie New York 12603 (US)**
Inventor: **Ray, Sudipta Kumar
19 Rose Lane
Wappingers Falls New York 12590 (US)**
Inventor: **Yuan, Leo
2729 Peachwood Court
San Jose California 95132 (US)**

(74) Representative: **Klocke, Peter, Dipl.-Ing.
IBM Deutschland GmbH Patentwesen und
Urheberrecht Schönaicher Strasse 220
D-7030 Böblingen (DE)**

(56) References cited:
**IBM TECHNICAL DISCLOSURE BULLETIN, vol.
20, no. 9, February 1978, pages 3729,3730, New
York, US; C.W. HO et al.: "Planar wiring repair
technique for the thin-film metal package via
solder evaporation"**

## Description

The invention relates to an interconnection change pad for use on a ceramic substrate receiving integrated circuit chips and having a multilayer chip interconnection system and a multilayer chip interconnection change system.

The trend in electronics today is to systems of ever-increasing component density. Increased component density permits designers to achieve greater speed and complexity of system performance while maintaining minimal system physical size. Additionally, increased component density enables circuit manufacturers to lower production costs owing to economies they can realize using integrated circuit technology.

The desire for increased component density has given rise to the so-called very large scale integrated circuit (VLSI). In such circuits, designers pack large numbers of components into individual integrated circuit chips. Subsequently, these chips can be ganged on a single substrate to form larger circuits and functional blocks for the system. To accommodate such high density circuits, designers have developed multilayer ceramic (MLC) substrates which permit the many terminals of a chip to be connected both to other chips and to circuits external to the substrate in a space efficient manner.

MLC substrates are well known and have been described in such articles as "A Fabrication Technique for Multilayer Ceramic Modules" by H. D. Kaiser et al, appearing in *Solid-State Technology,* May 1972, pp. 35—40. As Kaiser et al explain in their article, green ceramic sheet, i.e. ceramic powder held together in sheet form by temporary organic binders, are metallized using conventional screen printing. The metallized sheets are stacked, i.e. laminated, and thereafter fired, i.e. cured, to form a monolithic package. This structure provides a three-dimensional wiring system to facilitate the chip interconnection pattern in what was formally waste or inaccessible space in the ceramic substrate. The use of this "waste space" results in the creation of a high density electronic package suitable for handling the high density integrated circuit chips. An example of a semiconductor module including a multilayer ceramic substrate is given in U.S. Patent 4 245 273.

As shown in that U.S. Patent, the MLC substrate includes multiple layers of interconnection metallization, i.e. interconnection wiring, extending orthogonally in alternating layers in the substrate, i.e. in the X direction in one layer and in the Y direction in the next layer, etc., where the X and Y directions are the cartesian coordinates defining points in the plane of any layer. Additionally, the substrate includes vertically extending metallization, i.e. Z direction wiring, commonly referred to as "vias", extending from and between the internal wiring and the integrated circuit chips at the chip mounting face of the substrate and/or interconnection pins at the pin face, i.e., the major surface of the substrate opposite the chip mount face. The interconnection pins in this arrangement enable the substrate to be mounted on larger cards which form larger subdivisions of the total system.

Because of the great number, literally hundreds, of interconnection circuits required to join the chips to each other and to circuits external to the substrate, and because there are literally hundreds of device circuits included in the integrated circuit chips themselves, there is a great likelihood that one or more of these circuits will be faulty. Manufacturers, therefore, find it necessary to include means on the substrate for effecting changes to the circuits of the chip interconnection system.

The desirability of such a change system is further motivated by the need to effect changes in the chip interconnection pattern to accommodate design changes which may arise after the substrate have been initially laid out, or to accommodate special considerations which may be dictated by the use environment. Yet further, because of the high component density and associated complexity, each MLC chip combination is expensive to build, notwithstanding the cost efficiencies associated with high integration. Accordingly, manufacturers all the more desire an interconnection change system which can avoid the MLC, chip combination from being rendered worthless because of interconnection defects.

An example of a system for effecting changes to chip interconnection system is provided in European patent application 82 110 207.6. This application describes a change system including an auxiliary set of orthogonal disposed change wires disposed in alternating layers of the MLC body which are connected to change pads disposed on the substrate chip mount surface by means of vertically disposed change metallization, i.e. vias, also provided in the substrate body. Additionally, the change system includes chip interconnection contact pads (chip c.c. pads) at the substrate chip mount surface which are electrically severably and which are connected to the chip interconnection wiring buried in the substrate body.

In accordance with the teaching of European patent application 82 110 207.6, by providing a discrete jumping wire from the chip c.c. pad to the change pad and severing the connection between the chip c.c. pad and the interconnection wiring, a new wiring pattern for a chip circuit, which is isolated from the old, can be effected. The inventors point out that with their approach, new connections can be inserted, and old connections deleted. This flexibility permits the correction of defects arising either from faulty interconnection wiring in the MLC substrate or in the integrated circuit chips. Additionally, design changes for the chip interconnection pattern may also be effected in this way.

The disclosed change pad, however, is limited. Due to the form of the change pad, a modification of the interconnection pattern may not subsequently be further modified without risk of destroying the change pad, or the c.c. pad or both; with the consequence that the associated chip and possibly the MLC may be rendered useless.

More particularly, the disclosed change pad takes the form of a dog bone having expanded ends joined by a strapping section. The expanded pad ends are respectively connected to vias which connect to discontinuous sections of a change line buried in the substrate. The change pad strapping section interconnects the buried line sections at the substrate chip mount surface rendering the change line continuous. Where a portion of the change line is to be used, a discrete jump wire is bonded between one of the c.c. pad and one of the change pad ends. Additionally, the change pad and c.c. pad strapping sections are appropriately severed to isolate the change line from undesired sections of it and the original interconnect circuit. The isolated change line may thereafter be wired in as desired by bonding another fixed lead at the other end of the change line between another c.c. pad and another change pad, the appropriate severing of c.c. and change pad strapping sections also being effected.

Unfortunately, with the known change system, if the change line itself is found to be defective or the chip to which it is newly connected is found defective, it becomes necessary to make further changes to the original change. This requires that the original jump wire be removed. Since the jump wires are physically bonded to both the c.c. pad and the change pad, their removal can physically destroy one or the other or both. The difficulties associated with removing change jump leads is aggravated where manufacturers seek to minimize the amount of metal used for the change pad and the c.c. pad, as it becomes less likely that a bonded jump lead can be removed without damaging or destroying the pads.

The invention as claimed is intended to remedy these drawbacks. It solves the problem of how to design an interconnection change pad that is capable of accommodating multiple changes and avoids the need for eliminating any jump wire previously inserted.

The invention is described in detail below with reference to the drawings of which:

Fig. 1 is a top plane view of a portion of an MLC substrate including integrated circuit chips mounted thereon as known in the prior art;

Fig. 2 is a simplified cutaway isometric of an MLC substrate including integrated circuit chips mounted thereon as known in the prior art;

Fig. 3 is a diagrammatic representation in simplified isometric form of changes made to interconnection system of an MLC as known in the prior art;

Fig. 4 is a diagrammatic representation in simplified isometric of changes made to an MLC substrate interconnection system using the interconnection change pad in accordance with this invention;

Fig. 5 is an isometric view of the interconnection change pad known in the prior art as compared with the interconnection change pad in accordance with this invention.

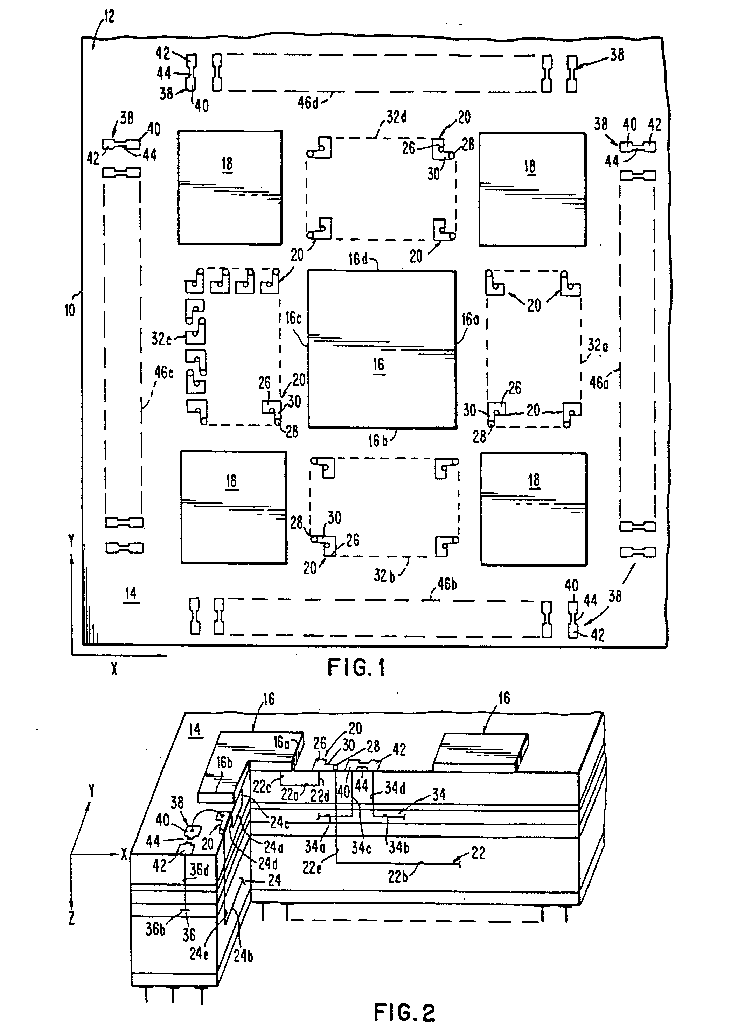

A section of an MLC integrated circuit chip mounting substrate 10 is shown in top plane view in Fig. 1. As shown, a cell 12 of the MLC, chip combination is depicted. Cell 12 is taken from the lower left of substrate 10 and would be substantially repeated in a two dimensional matrix over the substrate surface 14; one dimension of the matrix being the X direction and the other the Y direction of the cartesian coordinates defining points in the plane of substrate surface 14. As will be described more fully hereinafter, pad clusters 46a—d depicted in cell 12 are typically shared between adjacent cells for economy and are not repeated. Clusters 46a—d have however been included in describing cell 12 to simplify explanation.

As seen in Fig. 1, cell 12 includes an integrated circuit chip 16 "flip chip", i.e. face down, mounted at substrate mounting surface 14. Chip 16 is mounted using conventional controlled collapse chip connections (C-4). In accordance with a C-4 mount, solder balls of particular composition are provided at the chip metallization pattern for joining the chip to a "footprint" receiving pad provided at substrate surface 14. The chip mount footprint is personalized to the chip being mounted and is connected to the interconnection system of substrate 10. For simplicity, the C-4 chip mount features have not been shown as they do not form a part of this invention. A more detailed description of the chip mount may be found in the above referred to U.S. Patent 4 245 273.

As shown in Fig. 1, cell 12 may include capacitors 18 provided with chip 16 to satisfy circuit electrical requirements. As shown, the capacitors may be mounted to substrate surface 14 in a fashion similar to chip 16.

As best seen in Fig. 2, substrate 10 includes a chip interconnection system having a multiplicity of metal lines extending through the volume of substrate 10. The lines interconnect the substrate mounted chips 16 and additionally couple the chips to signal and power circuits external to substrate 10.

Continuing with reference to Fig. 2, the interconnection system includes metal lines oriented in the X, Y and Z directions such that a single interconnection circuit may include X, Y and Z line components. For simplicity of explanation, portions of two interconnection circuits for chip 16 of cell 12 only are shown in Fig. 2. As shown, a first interconnection circuit portion 22 extends in the X and Z directions and includes X direction line components 22a, 22b interconnected by Z direction components, i.e. vias 22c—e. Similarly, a second interconnection circuit portion 24 extends in the Y and Z directions having Y direction components 24a, 24b. Like circuit 22, components 24a, 24b are interconnected by Z direction line components 24c—e.

As shown in Fig. 2, the interconnection circuit components are accessible at substrate surface 14 where horizontal components 22a, b; 24a, b are respectively joined by interconnect contact (c.c.) pads 20 and respective vias 22d, e and 24d, e. While not essential for a simple interconnection system, pads 20 are more properly elements of the interconnection change system to be discussed hereinafter as they provide access to the interconnection circuits to facilitate their change.

More particularly, and as shown in Figures 1 and 2, each c.c. pad 20 is formed to be severable so that the the substrate interconnection circuit can be interrupted. C.C. pad 20 associated with circuit portion 22 is typical of all pads 20. As seen in Fig. 2, it includes a segment 26 connected to via 22d, a segment 28 connected to via 22e and a strapping segment 30 which joins segments 26 to 28 rendering it continuous. Accordingly, when it is desired, strapping segment 30 may be severed to interrupt and isolate the chip interconnection circuit as, for example, when a change in the interconnection circuit is sought to be effected.

As shown in Fig. 1, pads 20 are arranged in clusters 32a—d disposed at the sides of integrated circuit chip 16. Particularly, a first cluster 32a is arranged adjacent chip side 16a, a second cluster 32b adjacent chip side 16b, a third cluster 32c adjacent chip side 16c and a fourth cluster 32d adjacent chip side 16d on surface 14 of substrate 10.

Each cluster contains a plurality of c.c. pads 20, each pad for accessing an interconnection line component attached thereto which is associated with a chip contact proximate the respective chip side. Cluster 32a accesses line components associated with chip contacts proximate chip sides 16a, 32b line components and contact proximate side 16b, 32c with line components and contact proximate side 16c and 32d with line components and contact proximate side 16d.

As shown in Fig. 2, the interconnection line components are arranged to fanout from the chip and its contacts in preferred directions. Particularly, X direction line components fanout from chip sides 16a, c while Y direction line components from fanout from chip sides 16b, d. Accordingly, clusters 32a, c and 32b, d, respectively, access X and Y direction line components.

As suggested by the form of clusters 32a—d, multiple X and Y direction line components extend from each chip side. These components extend in their respective X and Y plane spaced in substrate 10 in the Z direction. Each plane contains multiple, parallel X or Y line components spaced from one another in the direction of the other, i.e. multiple X direction extending line components spaced in the Y direction, and multiple Y direction extending line components spaced in the X direction. The various X and Y components being interconnected with each other and the substrate surface by means of Z direction vias.

As noted above, this scheme is exemplified in interconnection circuit portions 22 and 24 shown in Fig. 2. Particularly, via 22c is seen to extend from a chip contact proximate chip side 16a to x direction line component 22a which is joined to via 22d, c.c. pad 20, via 22e and X direction line component 22b. Likewise, via 24c is seen in Fig. 2 to extend from a chip contact proximate proximate chip side 16b to Y direction line component 24a which is joined to via 24d, c.c. pad 20, via 24e and Y direction line component 24b. While not shown for the sake of simplicity, line components extend away from chip sides 16c, d in a similar fashion.

Continuing with reference to Figures 1 and 2, MLC substrate 10 also includes metallization to effect changes to the chip interconnection system, e.g. circuits, 22, 24. Particularly, and as best seen in Figure 2, substrate 10 contains change metallization which includes horizontally disposed X segments 34 and Y segments 36. Segments 34 and 36 are interconnected with substrate surface 14 by respective Z direction components, i.e. vias. As shown in Fig. 2, segments 34, 36 each include discontinuous horizontal sections 34a, b, etc., and 36a, b, etc., respectively, which are joined, i.e. made continuous, by their vias, e.g. 34c, d; 36c, d respectively and change pads 38 provided at substrate surface 14.

Change pad 38 associated with change line 34 is typical of all pads 38. As seen in Figure 2, it is in the general shape of a dog bone having a first expanded end 40 connected to via 34c and associated buried line section 34a and a second expanded end 42 connected to via 34d and associated buried line section 34b. Change line sections 34a—d are joined by a strapping section 44 of pad 38. As best seen in Figure 2, while only a portion of line 36 can be seen due to the nature of the figure, it should be understood that an arrangement similar to that for line 34 also exists for line 36. Particularly, section 36a is interconnected with an associated change pad end 40 by via 36c. Pad 40 in turn is connected by section 44 to pad end 42, via 36d and line section 36b.

In this arrangement, strapping sections 44 of change pads 38 are made of a size and composition which is readily severable as, for example, by a laser beam.

As shown in Figure 1, clusters of change pads 38 surround chip 16 in a fashion similar to c.c. pad clusters 32a—d. Particularly, a first cluster 46a of change pads 38 are arranged opposite chip side 16a and spaced therefrom by c.c. pad cluster 32a. Additionally, second, third and fourth arrays 40b, 46c, 46d, respectively, of change pads 38 are provided opposite respectively chip sides 16b, 16c and 16d displaced therefrom by c.c. pad clusters 32b, 32c and 32d. As can be appreciated from Figures 1 and 2, change lines 34 extends in the X direction between change pads 38 of arrays 46a and 46c. Similarly, change line 36 extends in the Y direction between change pads 38 of clusters 46b and 46d.

This arrangement facilitates a multiplicity of change lines, e.g. 34, 36 extending through substrate 10 in a fashion similar to that described for interconnection circuits, e.g. 22, 24. Like the interconnection circuits, the change circuits include parallel spaced change line segments dispossessed in X and Y substrate planes. The X direction change line sections are provided as discontinuous line sections spaced in the Y direction and the Y direction change line section as discontinuous line sections spaced in the X direction. The discontinuous segments are formed into continuous lines by their associated vias and change pads.

As suggested in Fig. 2, the number of substrate planes dedicated to change lines is substantially less than the number of planes dedicated to the interconnection system. This is evident from the relative thickness for the substrate stratum 48, 50 dedicated to the change system and interconnection system respectively. The provision of only a limited number of change circuits is based on the assumption substantially less than half the original interconnect circuits will need change.

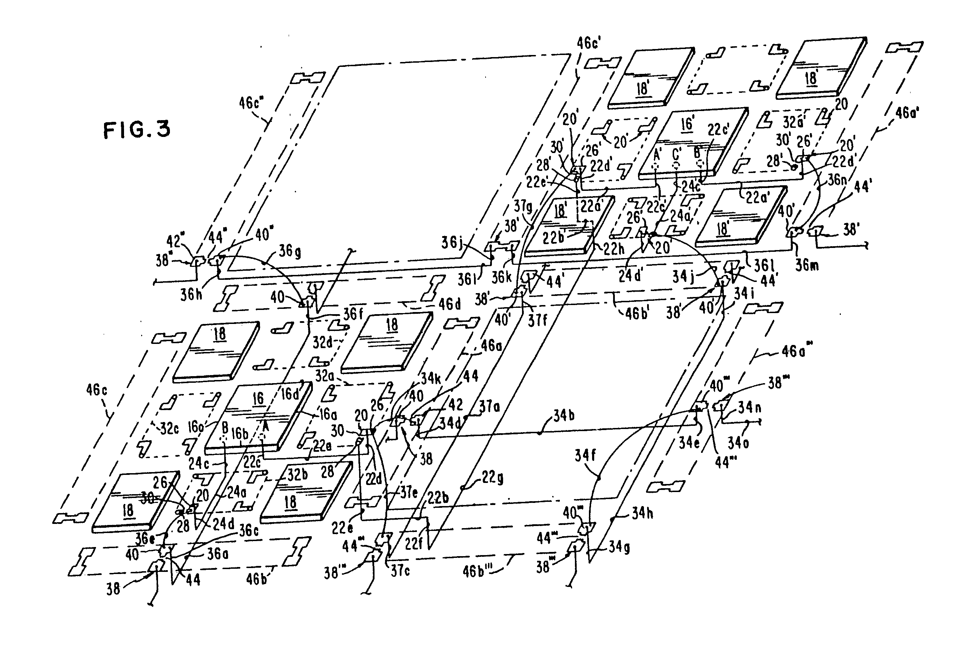

As noted above, not all the elements represented in cell 12 depicted in Figure 1 are repeated in each cell. Particularly, the change pad arrays 46 between adjacent chips, are shared. For example, and with reference to cell 12 depicted in Figure 1, chips exist in the X direction opposite chip side 16a and in the Y direction opposite chip side 16d. Accordingly, change pad arrays 46a and 46d are shared between the adjacent chips 16, 16″ and 16‴ as best seen in Figure 3. Since there are no chips adjacent chip sides 16b and 16c, as they are proximate the substrate edge, change pad arrays 46b and 46c are exclusively associated with cell 12.

As explained in the introductory remarks, an interconnection change system as described is capable of inserting new interconnections and deleting old ones. As a result, the change system can correct defects arising in either the MLC substrate wiring or in the chip circuits where the chips include circuit redundancy. Additionally, design changes to the interconnection pattern initially laid out may also be undertaken with this change system.

Figure 3 illustrates the type of changes which this system can effect. Particularly, the addition of a new circuit, the exchange of a circuit to avoid a defective substrate line and the exchange of a circuit to avoid a defective chip circuit are shown.

With reference to Figure 3, change circuit 36 shown there illustrates the addition of a new interconnection line between points B, B′ of chips 16, 16′, respectively. Such a change might be occasioned by an engineering amendment which calls for additional circuitry of chip 16′ to be combined with the circuitry of chip 16. While the order of the following step should be viewed as illustrative rather than compulsory, such a change could be effected as follows. Assume that point B on chip 16 is connected to a chip circuit initially intended to remain incomplete. Accordingly, the chip fanout circuit to which point B is necessarily connected by virtue of the mating of chip 16 to substrate 10 is severed. Specifically, and as seen in Fig. 3, strap 30 of c.c. pad 20 associated with point B of chip 16 is severed. The chip fanout therefore carries chip point B over via 24c, Y component 24a and via 24d to first end 26 of a c.c. pad 20. There the fanout circuit ends by virtue of the severing of strapping section 30.

To join point B of chip 16 to point B′ of chip 16′ a discrete jump wire 36e is inserted between c.c. pad 20 associated with point B and a proximate change pad 38 located in change pad cluster 46b. In preferred form, discrete jumper 36e is a wire which may be bonded in a conventional fashion to end 26 of the relevant c.c. pad and end 40 of the relevant change pad. Following insertion of wire 36e, strapping section 44 of pad 38 associated with via 36c in cluster 46b and strapping section 44 of a pad 38 associated with via 36f in cluster 46d are severed to isolate associated Y direction change line segment 36c, a. f. Subsequently, another jump wire 36g is bonded between change pad end 40 associated with via 36f and change pad end 40″ associated with via 36h in cluster 46c″. Since chip 16′, the chip to which the new connection is to be made, is displaced by one cell in the Y direction from chip 16, change line 36 need only extend one unit cell in the Y direction before being transferred to the X direction to complete the connection. As shown, via 36h is associated with X direction change line segment 36i. Thus, jumper 36g transfers the change circuit from the Y to X direction. Change circuit 36 thereafter continues in the X direction two cells to reach a change pad 38′ in cluster 46a′ proximate to point B′ on chip 16′, associated with via 36m as shown in Fig. 3. Thereafter, another discrete jump wire 36n is bonded between change pad end 40′ associated with via 36m and a c.c. pad 20′ contained in cluster 32a′ associated with chip point B′. At the c.c. pad in cluster 32a′, the c.c. pad strapping section 30′ is severed to isolate the interconnection fanout 22d′, b′, c′ and point b′ of chip 16′ from the remainder of the interconnection circuit, i.e. 22e′, b′, etc., not shown. By this arrangement, a change circuit 24c, a, d, 36e, c, a, f, g, h, i, j, k, l, m, n, 22d′, a′, c′ is newly added to connect point B of chip 16 to point B′ of chip 16′.

In mapping the change circuit, a direction and connection strategy is selected to minimize the length of the discrete change wires and the buried change line segments with preference for minimizing the length of the discrete change wires. This is done to minimize the effects of inductance and capacitance which would otherwise detract from circuit performance. As seen in Fig. 2, the location of the chip points to be connected (i.e. B, B′) decides the c.c. pad clusters and associated change pad clusters which will be used. In the illustration given in Figure 2 for new line 36, point B is proximate chip side 16b. Accordingly, the proximate c.c. pad cluster and change pad clusters are 32b and 46b, respectively. Additionally, because point b is more proximate to chip side 16c than 16a, the length of jump wire 36g minimized by directing it to change pad cluster 46c″ rather than 46c′. This is done at the expense of increased length of buried change line 36i which by virtue of its location within substrate 10 is less inclined to show parasitic effects. Likewise, because the point to which the connection is to made, i.e. point B' on chip 16', is proximate chip sides 16a', b', the final discrete jump wire 36n is selected to extend between a change pad in cluster 46a' and a c.c. pad in cluster 32a', respectively which are proximate chip sides 16a', b'.

As noted, this change system may also be used to exchange substrate interconnection circuits which are found defective. Circuit 37 shown in Figure 3 is an example. Assuming that initially point A of chip 16 is connected to point A' of chip 16' by interconnection circuit 22 and that a defect arises somewhere in circuit portion 22e, b, f, g, h, b', e'. A replacement circuit may be effected as follows. The order of the following step is not critical and the following sequence is considered illustrative only. First, strapping section 30 of c.c. pad 20 associated with point A of chip 16 and strapping section 30' of pad 20' associated with point A' of chip 16' are severed as, for example, with a laser. Thereafter, a discrete jump wire 37e is bonded between c.c. pad end 26 associated with via 22d and end 40''' of a change pad 30'''' associated with a via 37c in cluster 46b'''. Next, strapping section 44''' of pads 38''' in clusters 46b''' and section 44' of pad 30' in cluster 46b' are severed to isolate change line section 37c, a, f. Subsequently, another discrete jump wire 37g is bonded between change pad end 40' associated with via 37f in cluster 46b' and c.c. pad end 26' associated with fanout 22d', a', c' and point A' of chip 16'. With this change, circuit 37e, c, a, f, g is substituted for circuit section 22e, b, f, g, h, b', e'. Again, the interconnect strategy is to select a path that minimizes the length of both the discrete jumper wires 37e, g and the buried change line sections with preference to minimize the length of the discrete wires 37e, g.

Finally, in the case where the chip circuit is found to be defective or undesired, and an alternative circuit is available on the chip or another chip an exchange of chip circuits may be effected. In Figure 3 an exchange of circuit connection A—A' to A'—C' is shown. A change circuit 34 to be described is used to effect the exchange.

As in the previous examples, the order of the steps to effect the change is illustrative rather than mandatory. Additionally, while for figure economy, connection A—A', used to illustrate the change of a defective MLC circuit, has again been selected to illustrate change of a defective chip circuit, it will be assumed for this example that no prior change to connection A—A' have been made, i.e. connection A—A' is made by original circuit 22. Where circuit A—A' is to be replaced by circuit A—C', the initial step is to isolate chip points A and A'. Isolation can be effected as noted previously by severing strapping section 30 of pad 20 associated with via 22e and strapping section 30' of pad 20' associated with via 22e'. Thereafter, a discrete jump wire 34k is bonded between c.c. pad end 26 associated with via 22d and change pad end 42 of pad 38 associated with via 34d in cluster 46a. Thereafter, strapping sections 44, 44'''' of the change pads in clusters 46a and 46a''' respectively are severed to isolate change line section 34d, b, e from the remainder of change line 34. Next, another discrete jump wire 34f is bonded between pad end 40''' associated with via 34e in cluster 46a''' and pad end 40'''' associated with via 34g in cluster 46b'''. Thereafter, strapping section 44'''' of pad 38'''' associated with via 34g in clusters 46b''' and strapping section 44' of pad 38' associated with via 34i in cluster 46b' are severed to isolate Y extending change line segment 34g, h, i. Finally, another discrete jump wire 34j is bonded between change pad end 40' associated with via 34i in cluster 46b' and c.c. pad end 26' cvucluster 32b' associated with via 24d. Additionally, pad strap section 30' for pad 20' associated with chip point c' of chip 16 is severed to isolate the final section of the change circuit 24d', a', c'. Again, the change path is selected to minimize the length of the discrete jump wires and the buried change line sections with preference to minimize the length of the exposed discrete jump wires.

The interconnection change system described above is disclosed in European patent application 82 110 207.6. Additional features of the described change system may be found on reference to that application.

As also pointed out in the introductory remarks, the change system above described is limited. Particularly, changes of a change may not be readily effected without subjecting the change system c.c. pads 20 and/or change pads 38 to damage or destruction which could render the MLC, chip combination worthless.

More particularly, in the case where an interconnection change itself is found to be defective or undesirable, in accordance with the known change system it is necessary to remove one or more of the discrete jump wires in order to isolate the circuits to be changed. Since the discrete jump wires are bonded between the c.c. pads and change pads, the process of removing the discrete jump wires may give rise to tearing of the pad metallization or require residual amounts of the bond wire to remain at the pad surfaces. Both of these alternatives are undesirable from the standpoint of the mechanical and electrical integrity of the change system.

More particularly, in the case where the initial change to replace interconnection circuit A—A' with interconnection circuit A—C', i.e. change circuit 34 is itself found to be defective or undesired, it would be necessary to eliminate at least discrete jump wires 34k, and 34j. Accordingly, the possibility of damage or destruction of c.c. pad 20 in cluster 32a and/or change pad 38 in cluster 46a and/or change pad 38' in cluster 46b' and/or c.c. pad 20' in cluster 32b' is presented.

The present invention improves on the above described change system by avoiding the need to eliminate previously inserted jump wires to effect subsequent modifications of an earlier change.

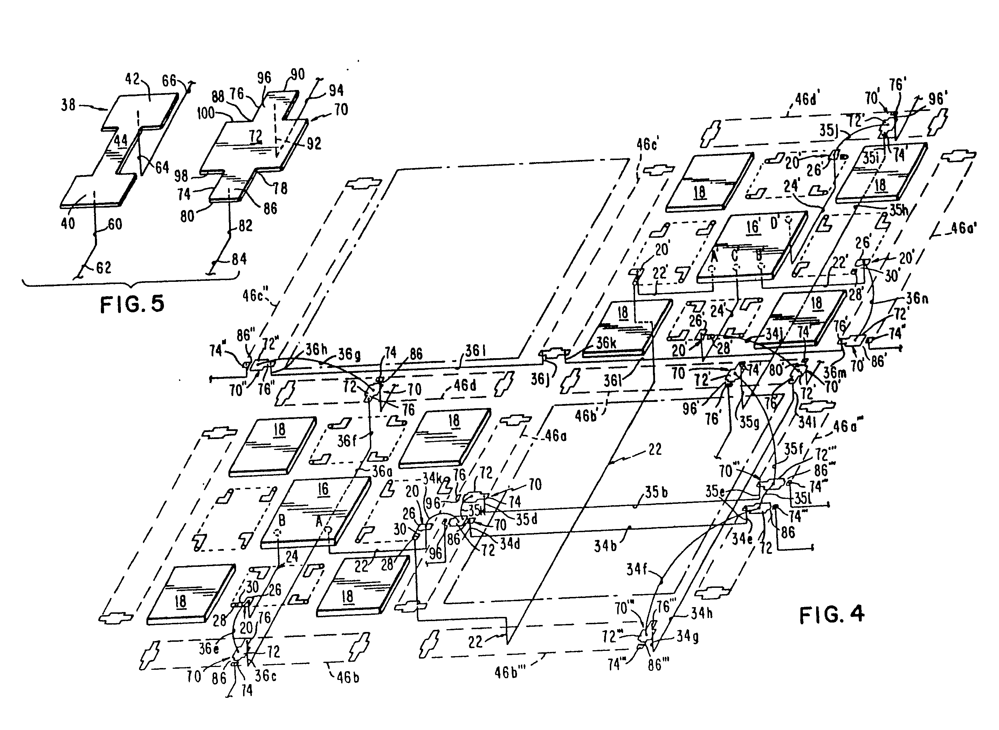

More particularly, the present invention is directed to a new change pad and improved interconnection change system and MLC including the new change pad. In accordance with this invention, a change pad is described to which discrete jump wires may be bonded such that when subsequent changes are desired, the initially inserted discrete change wires may be isolated from the initial change wiring buried segments and reused in subsequent changes thereby obviating the need for their removal. This end is achieved by forming the change pad to have a body element to which discrete jump wires may be bonded and to which one or more couplers may be severably appended which join the body element and any jump wires attached thereto to change line vias and buried segments. In accordance with this design, the body element to which the discrete jump wires are bonded may be made to float, i.e. be disconnected from the change lines in contrast to the known dog bone end bond pads which are intimately connected with the change system vias and buried change line segments. A better understanding of the change pad of this invention may be had by referring to Figure 5. In Figure 5 the previously known change pad 38 is shown at the left having a first end 40, a second end 42 and a strapping section 44 joining ends 40 and 42 as previously described. As shown, pad end 40 contacts a via 60 itself connected to a horizontally extending change line segment 62. Similarly, second end 42 is connected to via 64 which itself is joined to horizontally extending change line segment 66. Continuing between line segments 60, 62 and 64, 66 and respective pad ends 40, 42 is maintained by strapping section 44. As noted previously, changed line sections 60, 62 and 64, 66 may be interrupted by severing pad section 44.

However, and as also noted above, contact to change pad 38 and associated change lines 60—66 is accomplished by bonding a wire to either or both pad ends 40, 42. Therefore, once made, the bond wires and change line connections cannot be isolated without removing the bond wires.

In contrast, and as shown in Figure 5 at the right, the change pad 70 in accordance with this invention includes a body element 72 having a first coupler 74 and a second coupler 76. As shown, first coupler 74 has a first end 78 joined to body element 72 and a second end 80 attached to a change line via 82 which itself is connected to a horizontally extending change line segment 84. Ends 78 and 80 of coupler 74 are joined by a severable bridge section 86.

Similarly, second coupler 76 is provided at body element 72 having a first end 88 coupled to body element 72 and a second end 90 connected to a change line via 92 which is itself connected to horizontally extending change line segment 94. As in the case of coupler 74, coupler 76 has a severable bridge section 96 which connects coupler ends 88 and 90.

In the use of change pad 70, a discrete jump wire would be bonded to body element 72. Assuming that the desired connection would be to via 82 and horizontally extending change line segment 84, bridge section 96 of coupler 76 would be severed to isolate pad 70 from change via 92 and horizontally extending change line section 94.

If subsequently, changed line section 80, 82 is found undesirable for one reason or another, change pad 70 and body element 72 with any discrete wires bonded thereto may be isolated from all change wiring by severing remaining bridge 86 of coupler 74. Pad 70 and body element 72 with any attached wiring are accordingly totally isolated from the change system wiring, i.e. left floating relative to the change system. An additional discrete jump wire may therefore be used to join floating change pad 70 and any associated wires bonded thereto to a new change pad and associated change wiring. Thus, pad 70 may in effect be converted to a c.c. pad with a capacity for being interconnected in a new change scheme without the need for removing initially inserted discrete jump wires.

In Figure 5, change pad 70 in accordance with this invention is shown in preferred form. Particularly, pad 70 is shown formed as a single metallization element having a body section 72 of substantially rectangular shape, the body having two integrally formed couplers 74, 76 in the shape of substantially rectangular tabs. As shown, tab couplers 74, 76 are formed at opposite sides 98, 100 respectively of rectangular body element 72. Tab couplers 74, 76 have first ends 78, 88 respectively integrally formed with body element 72 such that the major axes of the respective tabs extending from the respective first tab ends to the respective second tab ends is oriented perpendicularly to body element sides 98, 100. Additionally, as shown, tab coupler 74, 76 are located approximately midway along the length of respective body element sides 98, 100.

As will be appreciated by those skilled in the art, while pad 70 has been shown formed with two couplers, additional couplers could be added as space permits. Still further, while pad 70 has been shown with a substantially rectangular body element, other forms as, for example, a circular body element with the number and position of couplers added as desired.

Pad 70 may be made at any convenient conductive composition provided couplers 74, 76 remain severable. A typical body element may be formed from a single metallization of molybdenum-nickel-gold or chrom-copper-gold or the like. The metallization can be sequentially deposited by standard fabrication methods such as electrochemical plating and vacuum evaporation.

Since as noted, for reuse, change pads 70 do not require removal of any discrete jump wires which may have been bonded to it, pads 70 may be made of minimal thickness as, for example, 5 to 10 micrometers, in order to conserve the amount of metal used.

Figure 4 shows the use of change pads 70 in an improved interconnection change system and MLC in accordance with this invention. Change pads 70 and improved change system depicted in Figure 4 are capable of effecting all of the changes which the prior art change system was capable of. Particularly, change pads 70 and its improved change system is capable of adding new interconnection circuits and deleting old ones. Accordingly, the new change pad and improve change pad system is capable of adding a new connection circuit, replacing a defective substrate circuit, or exchanging a defective or undesired chip circuit. Additionally, as noted the new change pad and improved change pad system is capable of effecting changes to a change without the need for removing a previously inserted discrete jump wire.

More particularly, Figure 4 illustrates the use of change pads 70 and the improved change system to add a new connection, B—B' between chips 16, 16' as known in the prior art (as shown in Figure 3); the replacement of an undesired chip connection A—A' with another connection A—C' also known in the prior art (shown in Figure 3); change of change A—C' to use a different substrate interconnection change circuit, without removal of previously inserted discrete jump wires, not possible in the prior art; and change of change A—C' to another connection A—D' again without removal of the previously inserted jump wires also not possible in the prior art. The replacement of a defective substrate circuit (illustrated in Figure 3 as new change circuit 37) is also possible with the new change pads 70 and improved change pad system. However, since the features of such a change using the new pad 70 follow directly from an illustration of a use of new pad 70 to insert a new line as depicted in Figure 4, the replacement of a defective substrate line for brevity has not been illustrated in Figure 4.

With regard to the insertion of a new connection, B—B' using new change pad 70 and the improved change pad system, tpe following sequence of steps, which is illustrative rather than compulsory, may be followed. Where, as before, that the fanout 24 for point B of chip 16 terminates at c.c. pad 20 which is isolated from the remainder of the interconnection circuit 24 by severing of strapping section 30, a discrete jump wire 36e is bonded between end 26 of pad 20 and body section 72 of change pad 70 in cluster 46b. Thereafter, bridge sections 86 of couplers 74 associated with change pads 70 in change pad clusters 46b and 46d, respectively, are severed to isolate Y direction extending change line section 36c, a, f. Thereafter, discrete jump wire 36g is bonded between body section 72 of change pads 70 in cluster 46d and bond pad 72'' of change pads 70'' in cluster 46c''. Next, bridge sections 86'' and 86' of change pads 70'' and 70' in clusters 46c'' and 46a' respectively are severed to isolate X direction extending change line segment 36h, i, j, k, l, m. Finally, a discrete jump wire 36n is bonded between body section 72' of change pad 70' connected to change via 36m and section 26' of c.c. pad 20', associated with point B' of chip 16'. Strapping section 30' of pad 20' is at this point severed to isolate interconnection circuit section 22' extending between c.c. pad 20' and point B' of chip 16'. As will be appreciated by comparing the addition of a new line using change pad 70 and the addition of a new line using prior art change pad 38, pad 70 is as capable to effect such changes as pad 38.

Likewise, change pad 70 is as capable as change pads 38 to effect the addition of a connection A—C' to replace a pre-existing connection A—A'. Particularly, and without limitation to sequence, strapping sections 30, 30' of respective c.c. pads 20, 20' associated with respective points A, A' of chips 16, 16' are severed to isolate fanout interconnections 22, 22'. Thereafter, a discrete jump wire 34k is bonded between end 26 of c.c. pad 20 associated with chip point A and body element 72 of change pads 70 in change pad cluster 46a. Thereafter, bridge sections 96 and 86''' of respective change pads 70 in cluster 46a and 70''' in clusters 46a''' are severed. This has the effect of isolating X extending change line segment 34d, b, e. Thereafter, discrete jump wire 34f is bonded between body element 72''' of change pad 70''' associated with via 34e in cluster 46a''' and body element 72''' of change pad 70'''' associated with change via 34g in cluster 46b'''. Subsequently, bridge section 86''' of change pad 70''' associated with via 34g in cluster 46b''' and bridge section 86' of change pad 70' associated with change via 34i in cluster 46b' are severed to isolate Y extending change line segment 34g, h, i. Thereafter, discrete jump wire 34j is bonded between body elements 72' of change pad 70' associated with change via 34i and section 26' of c.c. pad 20' in cluster 32b' associated with point C' of chip 16'. Additionally, strapping section 30' of c.c. pad 20' associated with chip point C' is severed to isolate fanout 24' completing the new connection A—C'.

Assume now, however, that it is desired to change a portion of the change circuit which newly connected point A to point C' particularly in the case where change circuit 34d, b, e is found defective. With the prior art system, it would be necessary to at least remove discrete jump wire 34k in order to isolate point A of chip 16 from the defective change line segment creating the possibility of damage or destruction of the change pad or c.c. pad. With the use of change pad 70 in accordance with this invention, however, discrete jumper wire 34k need not be removed. As with prior illustrations, the following sequence of steps is illustrative and not compulsory. Initially, point A is isolated from defective change line segment 34d, b, e by severing bridge section 86 of coupler 74. This has the effect of isolating body element 72 to which discrete jump wire 34k is bonded from all change system line elements. Thereafter, an additional discrete jump wire 35k is bonded between isolated body element 72 of change pad 70 associated with chip point A and another change pad body element 72 contained in change pad cluster 46a as shown. Thereafter, bridge sections 96 of pad 70 in cluster 46a and 86''' of pad 70'''' contained in cluster 46a''' are severed to isolate change line section 35d, b, e. Next, another discrete jump wire is bonded between body section 72''' of pad 70''' associated with via 35e and body element 72''' of change pads 70''' associated with change via 34e. Since change pad 70''' associated with change via 34e is already connected to point C' by virtue of the remainder of change circuit 34, i.e. 34g, h, i, j, 24', the new path is thereby completed.

In order to assure isolation of the new change line from any effects which may arise as a result of defective change line segments 34d, b, e, bridge section 96''' of pad 70''' associated with via 34e may also be severed.

Finally, in the case where it is desired to change a chip connection which has previously been changed, for example, A—C', to another connection, for example, A—D', new change pad 70 and the improved change system may be used to effect the change of the change without need for removing previously inserted jump wires. For the following discussion it will be assumed that change circuit 35 previously discussed had originally not been made and that substrate change circuit 34, 24' is acceptable but that it is desired to change connection A—C' to connection A—D'. Again, the following sequence of steps is illustrative rather than compulsory. Accordingly, chip point A is again isolated from change line 34 by severing bridge section 86 of change pad 70 associated with chip point A. Thereafter, a discrete jump wire 35k is bonded between body elements 72 of change pad 70 associated with chip point A and body element 72 of change pad 70 associated with change via 35k. Thereafter, bridge section 96 of pad 70 associated with change via 35d in cluster 46a and bridge section 86''' of change pad 70''' associated with change via 35e in cluster 46a''' are severed to isolate X extending change line section 35d, b, e. Subsequently, a discrete jump wire 35f is bonded between body element 72''' of pad 70''' associated with change via 35e in cluster 46a''' and body element 72' of change pad 70' associated with change via 35g in cluster 46b'. Next, bridge sections 96' of change pads 70 associated with change vias 35g in cluster 46b' and 35i in cluster 46d' are respectively severed to isolate Y extending change line segment 35g, h, i. Thereafter, a discrete jump wire 35j is bonded between body element 72' of change pad 70 associated with via 35i in cluster 46d' and section 26' of c.c. pad 20' associated with fanout circuit 24' and contact point D' of chip 16', strapping section 30' of c.c. pad 20' being severed to isolate fanout 24' from the remainder of the interconnection circuit. Again, to assure that no spurious effects may arise from line segments unused, previously utilized change pads may be isolated, i.e. rendered floating, by severing any bridge sections which connect respective body sections to change line sections.

## Claims

1. A multilayer ceramic substrate receiving integrated circuit chips and having a multilayer chip interconnection system and a multilayer chip interconnection change system, characterized by an interconnection change pad comprising:

a) a body element (72; Fig. 5) acting as a central bonding pad portion and formed on the substrate to which one or more leads are or can be joined for electrically connecting the body element with one or more circuits of the chip interconnection system, and

b) one or more couplers (74, 76) being electrically connected to one or more change line vias (82, 84; 92, 94) of the chip interconnection change system, and having a smaller dimension that said body element and each being integrally formed with the body elements the couplers being severable from the body element to isolate the body element from one or all of the chip interconnection change circuits.

2. A multilayer ceramic substrate according to claim 1 characterized in that the pad couplers are in the form of tabs each having a first end (78, 88) integrally formed with the pad body element, a second end (80, 90) connected to a vertical metallization (82, 92) of the chip interconnection change system and a bridge section (86, 96) joining the first and second coupler ends.

3. A multilayer ceramic substrate according to claim 2 characterized in that the pad body is substantially rectangular in form having a coupler extending from each of at least two opposite sides of the body, the couplers also having a substantially rectangular form, the major axis of the coupler extending perpendicularly to the body side (98, 100) with which the coupler is formed.

4. A multilayer ceramic substrate according to claim 2 characterized in that the pad coupler bridge section (86, 96) is laser severable.

5. A multilayer ceramic substrate according to claim 1 characterized in that the pad body and couplers are formed of a single layer of metallization.

## Patentansprüche

1. Mehrschichtiges keramisches Substrat zur Aufnahme integrierter Schaltungschips und mit einem Mehrschicht-Chipverbindungssystem sowie einem Mehrschicht-Chipverbindungs-Wechselsystem, gekennzeichnet durch einen Verbindungswechselanshcluß, folgendes enthaltend:

a) ein Körperelement (72; Fig. 5), welches als zentrales Verbindungsanschlußteil wirkt und auf dem Substrat ausgebildet ist, zu welchem sich eine oder mehr Zuleitungen vereinigen oder vereinigt werden können, um das Körperelement elektrisch mit einer oder mehr Schaltungen des Chipverbindugnssystems zu verbinden, und

b) ein oder mehrere Verbindungselemente (74, 76), die elektrisch mit einer oder mehr Wechselleitungsdurchverbindungen (82, 84; 92, 94) des Chipverbindungswechselsystems verbunden sind und deren Dimension kleiner ist als die des Körperelements, und die jeweils integral mit dem Körperelement geformt sind, wobei die Verbindungselemente vom Körperelement getrennt werden können, um das Körperelement von einer oder von allen Chipverbindungswechselschaltungen zu isolieren.

2. Mehrschichtiges Keramiksubstrat nach Anspruch 1, dadurch gekennzeichnet, daß die Anschlußverbindungselement in der Form von Kontaktzungen vorliegen, die jeweils ein erstes Ende (78, 88) haben, welches integral mit dem Anschlußkörperelement geformt ist, ein zweites Ende, (80, 90), das mit einer vertikalen Metallisierung (82, 92) des Chipverbindugnswechselsystems verbunden ist, und ein Brückenteil (86, 96), das die ersten und zweiten Enden des Verbindungs-elements zusammenfügt.

3. Mehrschichtiges Keramiksubstrat nach Anspruch 2, dadurch gekennzeichnet, daß der Anschlußkörper im wesentlichen rechtwinklig geformt ist, wobei sich ein Verbindungselement von jeder von mindestens zwei gegenüberliegenden Seiten des Körpers erstreckt, und wobei die Verbindungselemente ebenfalls eine im wesentlichen rechtwinklige Form aufweisen, und wobei sich die Hauptachse des Verbindungselementes waagerecht zu der Körperseite (98, 100) erstreckt, mit welcher das Verbindungselement geformt ist.

4. Mehrschichtiges Keramiksubstrat nach Anspruch 2, dadurch gekennzeichnet, daß das Brückenteil (86, 96) der Anschlussverbindung mittels Laser zerteilt werden kann.

5. Mehrschichtiges Keramiksubstrat nach Anspruch 1, dadurch gekennzeichnet, daß Anslußkörper und Verbindungselemente aus einer einzigen Metallisierungsschicht geformt sind.

**Revendications**

1. Substrat céramique à couches multiples recevant des microplaquettes à circuits intégrés et comportant un système d'interconnexions de microplaquettes à couches multiples et un système de modification des interconnexions de microplaquettes à couches multiples, caractérisé par un plat de modification d'interconnexions comprenant:

a) un élément formant corps (72; figure 5), agissant entant que partie centrale du plot de connexion et formé sur le substrat et auquel un ou plusieurs conducteurs peuvent être réunis pour raccorder électriquement l'élément formant corps et un ou plusieurs circuits du système d'interconnexion de microplaquettes, et

b) un ou plusieurs coupleurs (74, 76) étant raccordés électriquement à un ou plusieurs trous (82, 84; 92, 94) pour des conducteurs de modification du système de modification d'interconnexions de microplaquettes, et possédant des dimensions inférieures à celles dudit élément formant corps et étant constitués chacun d'un seul tenant avec cet élément formant corps, les coupleurs pouvant être séparés de l'élément formant corps de manière à isoler ce dernier à partir d'un ou de la totalité des circuits de modification d'interconnexions de microplaquettes.

2. Substrat céramique à couches multiples selon la revendication 1, caractérisé en ce que les coupleurs du plot de connexion sont réalisés sous la forme de languettes possédant chacune une première extrémité (78, 88) formée d'un seul tenant avec l'élément formant corps du plot, une seconde extrémité (80, 90) raccordée à une métallisation verticale (82, 92) du système de modification d'interconnexions de microplaquettes et une section formant pont (86, 96) réunissant les première et seconde extrémités des coupleurs.

3. Substrat céramique à couches multiples selon la revendication 2, caractérisé en ce que le corps du plot possède une forme sensiblement rectangulaire comportant un coupleur s'étendant à partir de chacun d'au moins deux côtés opposés du corps, les coupleurs possédant également une forme sensiblement rectangulaire, l'axe principal du coupleur étant perpendiculaire aux côtés (89, 100) du corps, avec lequel le coupleur est formé.

4. Substrat céramique à couches multiples selon la revendication 2, caractérisé en ce que la section formant pont (86, 96) des coupleurs du plot peut être sectionnée au laser.

5. Substrat céramique à couches multiples selon la revendication 1, caractérisé en ce que le corps du plot et les coupleurs sont formés d'une seule couche de métallisation.

FIG. 1

FIG. 2

1

FIG.3

FIG. 4

FIG. 5

3